Europäisches Patentamt

European Patent Office

Office européen des brevets

(19)

(11) **EP 0 691 555 B1**

(12) **EUROPÄISCHE PATENTSCHRIFT**

(45) Veröffentlichungstag und Bekanntmachung des
Hinweises auf die Patenterteilung:
**03.03.1999 Patentblatt 1999/09**

(51) Int Cl.⁶: **G02B 6/42**, H01S 3/025

(21) Anmeldenummer: **95108107.4**

(22) Anmeldetag: **27.05.1995**

(54) **Lasermodul**

Laser module

Module laser

(84) Benannte Vertragsstaaten:
**DE ES FR GB IT SE**

(30) Priorität: **27.06.1994 DE 4422322**

(43) Veröffentlichungstag der Anmeldung:
**10.01.1996 Patentblatt 1996/02**

(73) Patentinhaber: **ANT Nachrichtentechnik GmbH
D-71522 Backnang (DE)**

(72) Erfinder:
• **Möss, Eberhard
  D-71540 Murrhardt (DE)**
• **Hauer, Heiner
  D-70734 Fellbach (DE)**
• **Kuke, Albrecht, Dr.
  D-71549 Auenwald (DE)**

(56) Entgegenhaltungen:
**EP-A- 0 465 230         EP-A- 0 590 393**

## Beschreibung

Die Erfindung bezieht sich auf ein Lasermodul nach dem Oberbegriff des Anspruchs 1, wie aus der Europäischen Patentanmeldung EP-A-465 230 bekannt. Bei dem dort beschriebenen Lasermodul wird ein mikromechanisch strukturiertes Substrat als optische Bank eingesetzt, das zur Aufnahme eines Laserchips mit Zwischenträger, einer Kollimierungslinse, eines Isolators, einer Fokussierungslinse und eines Lichtwellenleiters (einer Faser) dient. Dabei sind für die verschiedenen optischen Komponenten jeweils getrennte Aufnahmevertiefungen vorgesehen. Dadurch muß der längs der optischen Bank geführte Strahl weit über die Substratoberfläche gelegt werden, damit die stirnseitigen Begrenzungen der Aufnahmevertiefungen den Strahl nicht behindern. Für die Faser ist in dieser Europäischen Patentschrift keine Justagemöglichkeit angegeben. Bei Montage in mikromechanisch vordefinierten Positionen ist zwar ohne Justage der Faser eine Faserpositionierung mit einer lateralen Genauigkeit von etwa 1μm möglich, jedoch hängt die Lage des Bildpunktes der Strahltaille des Laserlichtes im Bereich der Faserstirnfläche von der lateralen Positioniergenauigkeit des Lasers und aller Abbildungskomponenten ab. Um das Bild der Laserstrahl taille ebenfalls mit der erforderlichen Toleranz von 1 μm zur Faser festzulegen, müßte der Laser zur Kollimierungslinse mit einer um den Faktor 1/M eingeschränkten Toleranz festliegen, wobei M der Vergrößerungsmaßstab der Optik ist, die für eine optimale Strahlanpassung benötigt wird. Bei typischen Halbleiterlasern und Einmodenfasern liegt M bei 5. In axialer Richtung transformiert sich die in der Faserstirnfläche erforderliche axiale Toleranz von etwa 10 μm um den Faktor 1/M². Für die Toleranzen der Lage des Lasers relativ zur Kollimierungslinse wären somit laterale Toleranzen um 0,2 μm und axiale Toleranzen um 0,4 μm erforderlich. Wie oben erläutert, sind aber hier nur Toleranzen μm 10 μm erreichbar.

Ein weiteres Problem ergibt sich bei dem bekannten Lasermodul beim Einbau in ein hermetisch abzudichtendes Gehäuse, wenn die Faser durch die Gehäusewand zu führen ist. Die genannte Patentanmeldung gibt dazu keine geeigneten Anregungen.

Weitere Lasermodule sind aus der EP 259 888 B1 und der DE 42 32 327 A1 bekannt. In beiden Schriften wird ein Laser auf einem Chipträger beschrieben, dessen Licht mit einer ersten Linse kollimiert wird und die Gehäusewand über ein schräg gestelltes Planfenster durchdringt. Das Gehäuse wird dabei mit dem Planfenster hermetisch dicht abgeschlossen. Außerhalb des Gehäuses wird das Licht mit einer zweiten Linse auf die Stirnfläche einer Lichtleitfaser fokussiert. In der zweiten Schrift wird zusätzlich noch ein Isolator beschrieben, der außerhalb des hermetisch eingeschlossenen Volumens in einem Stutzen sitzt, der in das Gehäuse hineinragt und an seinem Ende das Fenster trägt.

Nachteilhaft an den bekannten Lösungen ist, daß der Laserchip auf einem Chipträger sitzt, der selbst mit geometrischen Toleranzen behaftet ist. Diese Toleranzen zusammen mit den Toleranzen des Laserchips selbst und den Montagetoleranzen des Laserchips auf dem Chipträger und des Chipträgers auf einer Montageplatte bestimmen in ihrem Zusammenwirken die Position der lichtaussendenden Fläche des Lasers. Da die Strahltaille des aus dem Laser austretenden Strahlbündels, das näherungsweise als ein Gaußstrahl mit elliptischem Profil beschrieben werden kann, Taillenhalbachsen von unter einem Mikrometer hat, muß die Position der ersten Linse zum Laser im Submikrometerbereich genau festliegen. Um diese Genauigkeit zu erreichen, ist in den Lösungen nach dem Stand der Technik eine Justierung der Faser in axialer und lateraler Richtung vorgesehen. Der Toleranzbereich für die Position des Lasers zur ersten Linse wird dadurch auf ein Volumen von ca. 20 · 20 ·20 μm³ rweitert. Dieser erweiterte Toleranzbereich ist in lateraler Richtung durch den maximal zulässigen Kippwinkel von ca. 1° der Achse des Lichtbündels zu den Linsenachsen und der Faserachse und des zulässigen Strahlversatzes des kollimierten Strahls zur Fokussierungslinse bedingt. Zu große Kippwinkel als Folge eines zu großen Lateralversatzes zwischen Laser und Kollimierungslinse führen insbesondere bei asphärischen Linsen zu einer komahaften Verzerrung des Strahls. Eine zu große axiale Dejustage zwischen dem Laser und der Kollimierungslinse führt einmal zu einer Veränderung des Vergrößerungsverhältnisses, was zu Koppelverlusten gegenüber dem optimalen Vergrößerungsverhältnis führt. Zum anderen wird der Strahl im Bereich der Fokussierungslinse stärker aufgeweitet, so daß der Linsenrand oder auch schon der zwischen den Linsen befindliche Isolator einen Teil des Strahls abschneidet, was ebenfalls zu Koppelverlusten führen würde.

Auch der erweiterte Toleranzbereich des Lasers läßt sich mit den Montageverfahren nach dem Stand der Technik justagefrei nicht oder nur mit sehr hohen Kosten und Aufwand erreichen. In der vorbekannten Lösung DE 42 32 327 A1 sind daher mehrere Justagemöglichkeiten angegeben. Zum einen eine dreiachsige aktive Justage der Kollimierungslinse zum ersten Laser. Dann eine laterale Justierung der zweiten Linse, die gleichzeitig zur Einstellung der Strahlrichtung dient, damit der fokussierte Strahl die schräg geschnittene Faser unter dem richtigen Winkel trifft. Zusätzlich ist eine dreiachsige Justage der Faser vorgesehen.

In der vorbekannten Schrift EP 0 259 888 B1 ist die Laserdiode ebenfalls auf einem Chipträger montiert. Dieser wird zur Vorpositionierung in Nuten auf einer Trägerplatte in einer Ebene senkrecht zur Strahlrichtung relativ zu einer Linse verschoben, die ebenfalls in dieser Trägerplatte montiert ist. Da der Laser während der Bewegung bei einer aktiven Justage in Betrieb sein muß, erhält man Probleme mit den Anschlußleitungen des Lasers und mit der Wärmeabfuhr. Auch nach der Fixierung liegt der Chipträger nur mit seiner Seitenfläche an eine Seitenfläche der Nut in der Trägerplatte an, was zu einem erheblichen Wärmewiderstand zwischen Chipträger und Trägerplatte und damit zu einer unzureichenden Laserkühlung führt.

In beiden vorbekannten Lösungen ist neben der Faserjustage noch eine aufwendige und kostenintensive Justage zwischen dem Laser und der ersten Linse erforderlich. In der vorbekannten Lösung DE 42 32 327 A1 wird zwischen den Linsen noch ein Isolator in den kollimierten Strahl gesetzt, um störende Rückwirkungen auf den Laser zu vermeiden. Solche Isolatoren wirken nach dem Faraday-Prinzip und haben in einem eng spezifizierten Wellenlängen- und Temperaturbereich eine sehr hohe Rückflußdämpfung, die je nach Typ (einstufig oder zweistufig) 30 bis 60 dB betragen kann. Verläßt man jedoch den spezifizierten Temperatur- oder Wellenlängenbereich, so nimmt die Rückflußdämpfung stark ab, was zu Fehlfunktionen des Lasers führen kann. Die Konstanz der Wellenlänge des Lasers wird in der vorbekannten Lösung durch eine Peltier-Regelung mit Thermistor-Temperaturmessung in Lasernähe erreicht. Der Isolator ist aber in einem Stutzen montiert, der in die Gehäusewand eingelassen ist.

Bei Änderungen der Gehäusetemperatur ändert sich daher auch die Temperatur des Isolators mit. Bei einer Änderung der Umgebungstemperatur oder der Laserleistung wird die Temperatur des Lasers über die Peltierregelung konstant gehalten. Dabei wird dem Laser über das Peltierelement Wärme entzogen und dem Gehäuse zugeführt. Da der Isolator mit dem Gehäuse in thermischem Kontakt ist, machen sich dort Temperaturschwankungen sogar noch verstärkt bemerkbar, wodurch die Dämpfungseigenschaften des Isolators verschlechtert werden.

Es ist Aufgabe der Erfindung, ein Lasermodul anzugeben bei dem die oben beschriebenen Nachteile vermieden werden.

Die Aufgabe wird durch ein Lasermodul mit den Merkmalen des Patentanspruches 1 gelöst. Vorteilhafte Weiterbildungen sind in den Unteransprüchen angegeben.

Die vorliegende erfindungsgemäße Lösung vermeidet die oben beschriebenen Mängel der vorbekannten Lösungen und führt noch weitere Verbesserungen ein. In der vorliegenden Lösung ist nur ein aktiver Justageschritt an einer unkritischen Stelle, nämlich an der Lichtwellenleiterseite erforderlich, die bei den vorbekannten Lösungen ebenfalls erforderlich ist. Hier liegen die erforderlichen Toleranzen im Bereich von 2 μm in den lateralen Richtungen und von 30 μm in axialer Richtung. Diese Toleranzen lassen sich durch bekannte Flansch-Justage-Verfahren und bei Fixierung mit Laserschweißpunkten einhalten.

Ein erfindungsgemäßes Ausführungsbeispiel des Lasermoduls wird anhand der Zeichnungen erläutert.

Es zeigen:

Figur 1 eine Draufsicht auf ein erfindungsgemäßes Lasermodul mit Butterfly-Gehäuse,

Figur 2 einen Längsschnitt durch obiges Lasermodul,

Figur 3 eine Ausschnittsvergrößerung von Figur 1,

Figur 4 die Aufnahme für den Laser mit Ausrichtungsmarken,

Figur 5 bis 7 Draufsicht, Seitenansicht und Ansicht der ersten Linse mit Isolator im eingelegten Zustand.

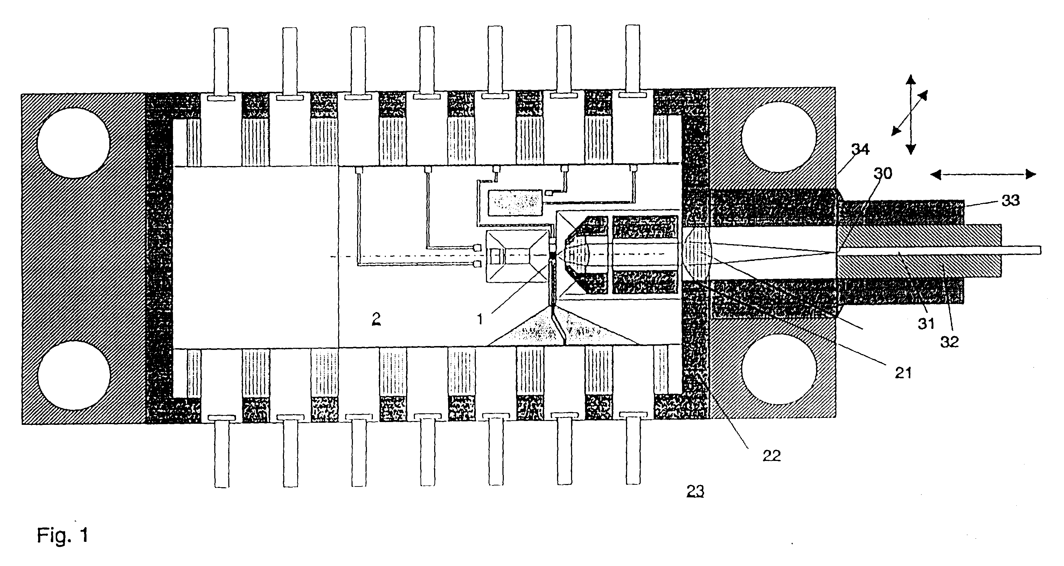

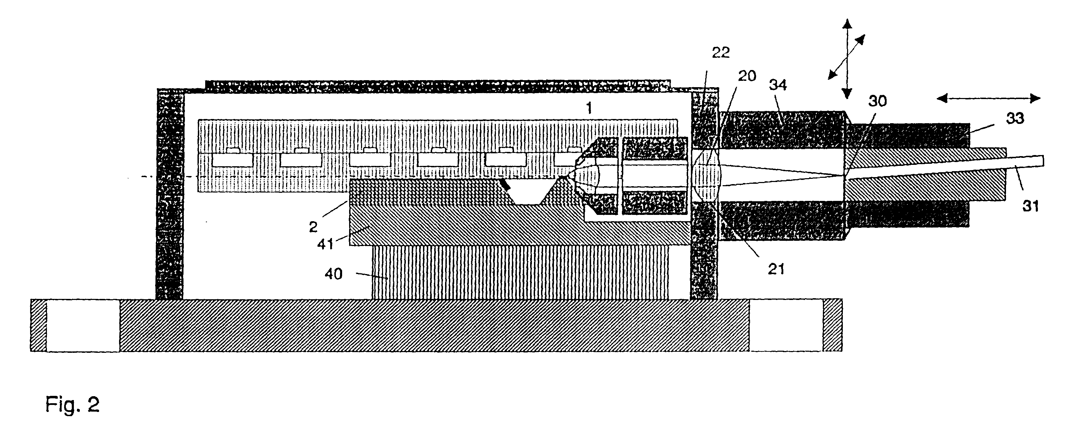

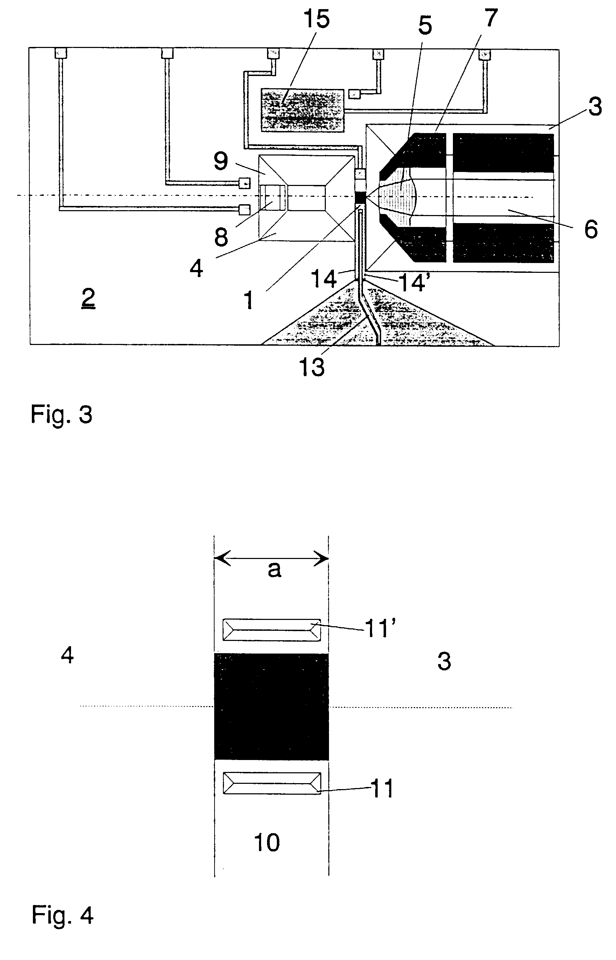

Die Figuren 1 und 2 zeigen in Draufsicht und Längsschnitt erfindungsgemäß ein Lasermodul. Der Laserchip 1 ist direkt auf einer mikromechanisch strukturierten Silizium-Trägerplatte 2 montiert. Diese Trägerplatte 2 ist in größerem Maßstab in Figur 3 dargestellt. Die Silizium-Trägerplatte 2 besitzt zwei anisotrop geätzte Nuten 3 und 4. Die Nut 3 dient zur Aufnahme der Kollimierungslinse 5 und des Isolators 6. Als Kollimierungslinse kann zur Vermeidung sphärischer Aberrationen und damit zur Verbesserung des Koppelwirkungsgrades vorzugsweise eine asphärische Linse verwendet werden. Die Linse 5 besitzt einen zylindrischen Rand 7 oder eine Fassung mit einem zylindrischen Rand 7. Der Außendurchmesser der Linse 5 bzw. der Linsenfassung ist vorzugsweise ebenso groß wie der Außendurchmesser des ebenfalls zylindrischen Isolators 6. Es ist jedoch auch möglich, daß Linse und Isolator unterschiedliche Außendurchmesser haben, in diesem Fall muß die Nut 6 in den Bereichen für die Linsenaufnahme und für die Isolatoraufnahme unterschiedliche Breiten haben. Die Nut 4 dient zur Aufnahme der Monitordiode 8, die zur Leistungsregelung des Laserchips 1 erforderlich ist. Diese Monitordiode 8 wird auf der dem Laser abgewandten schrägen Rückwand 9 der Nut 4 montiert. Der Laser 1 sitzt auf dem zwischen den Nuten 3 und 4 verbleibenden Steg 10. Die Breite des Steges entspricht ungefähr der Länge des Lasers. Bei Lasern, deren strahlende Zone auf der Oberseite des Chips liegt (Epiup), ist es vorteilhaft, die Breite a des Steges 10 ebenso groß oder einige Mikrometer größer als die Chiplänge 1 des Laserchips zu wählen, da dann auch bei etwaigen Montagetoleranzen die Grundfläche des Lasers überall in gutem Wärmekontakt mit dem Siliziumsubstrat ist. Bei Lasern, deren strahlende Zone auf der Unterseite liegt (Epi-down), ist es dagegen vorteilhaft, wenn die Stegbreite a gleichgroß oder um wenige Mikrometer kleiner als die Chiplänge ist, damit bei einer etwaigen Montagetoleranz der Strahl nicht durch das Siliziumsubstrat abgeschattet wird.

Nach dem Stand der Technik werden Laserchips auf Wärmesenken mit senkrecht zur Montagefläche befindlichen Stirnflächen montiert. Bei Epi-down-Lasern muß dabei die Kante zwischen der vorderen Stirnfläche und der Montagefläche möglichst scharf sein, damit einerseits ein guter Wärmeübergang zwischen Laserchip und Wärmesenke vorhanden ist und andererseits der Laserstrahl durch die Wärmesenke nicht abgeschattet wird. Die senkrechte Begrenzung der Wärmesenke nach dem Stand der Technik schnürt aber den Wärmefluß vom Laser über die Wärmesenke ein, wodurch auch bei gut leitenden Wärmesenken, wie zum Beispiel Diamant, der Wärmewiderstand erhöht wird. Bei der erfindungsgemäßen Lösung sind dagegen die vor den Laserspiegeln befindlichen Seitenflächen der Nuten 3 und 4 infolge der Geometrie der anisotropen Ätzung von Silizium um den Böschungswinkel α = 54,7° gegenüber der Substratoberfläche geneigt. Dieser Winkel ist einerseits groß genug, damit auch bei Lasern mit einem sehr breiten Fernfeld kein Licht abgeschattet werden kann. Andererseits ist der Winkel wesentlich kleiner als 90° wie bei den Wärmesenken nach dem Stand der Technik. Dadurch können sich die Wärmeflußlinien über die Grundfläche des Laserchips hinaus ausbreiten, was zu einer Verringerung des Wärmewiderstandes führt. Die durch einen hochpräzisen anisotropen Ätzprozeß hergestellten Kanten zwischen der als Montagefläche dienenden Oberfläche des Substrates und den Seitenflächen der Nuten 3 und 4 sind sehr scharf und in ihrer Position hochgenau. Dadurch ist es möglich, die Breite a des Steges 10 mit einer Toleranz von wenigen Mikrometern an die Länge 1 des Laserchips anzupassen und somit einen guten Wärmekontakt zwischen dem Laserchip und dem Siliziumsubstrat ohne Gefahr der Strahlabschattung zu erreichen.

Die Figur 4 zeigt einen vergrößerten Ausschnitt aus dem mittleren Bereich des Steges 10, der für die Aufnahme des Lasers 1 vorgesehen ist. An beiden Seiten der Aufnahmefläche ist je eine V-Nut 11 und 11' anisotrop geätzt, die als Marken zur Ausrichtung des Laserchips dienen. Bei der Montage wird der Laser unter visueller Beobachtung zwischen diese beiden Marken positioniert. Dabei muß der Laser nicht im aktiven Betrieb sein wie im Stand der Technik, sondern es genügt hier eine passive Justage, die wesentlich einfacher durchgeführt werden kann, da der Laser noch nicht kontaktiert sein muß. Bei der passiven Justage nach den Marken 11 und 11' ist eine Positioniergenauigkeit von wenigen Mikrometern möglich. Da die Marken 11 und 11' im gleichen anisotropen Ätzprozeß wie die Nuten 3 und 4 hergestellt werden, liegt ihre gegenseitige Lagetoleranz im Bereich von weniger als 2 Mikrometern. Dadurch erhält man eine sehr genaue Ausrichtung zwischen dem Laser und der Kollimierungslinse 5 sowie dem Isolator 6.

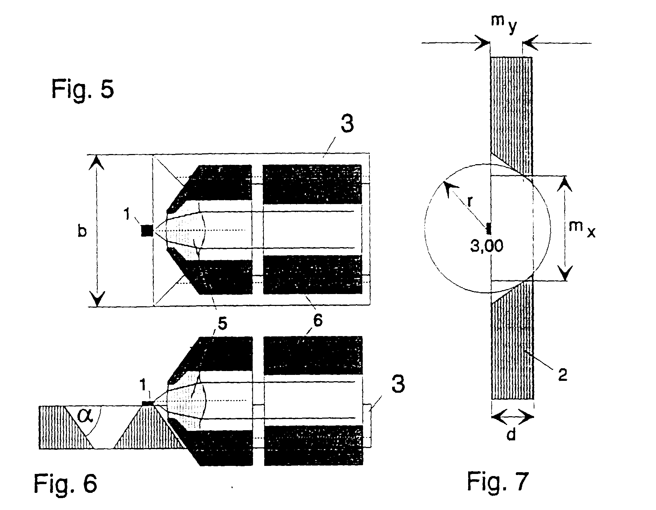

Die Position der Kollimierungslinse 5 wird durch die Lage und Größe der Nut 3 eindeutig festgelegt. Die Dicke d des Silizium-Substrates 2 wird dabei abhängig vom Radius der Kollimierungslinse so gewählt, daß die berührende Mantellinie noch auf den Seitenflanken der Nut 3 aufliegen. In den Figuren 5, 6 und 7 ist die eingelegte Linse mit Isolator in drei Schnittebenen mit Ansicht von oben, von der Seite und von vorn dargestellt. Um einen kleinen Arbeitsabstand zwischen dem Laser und der Kollimierungslinse zu erreichen ist hier die Fassung der Kollimierungslinse in ihrem vorderen Teil konusartig geformt und damit an die schräge Stirnflanke der Nut 3 angepaßt. Die Höhe der Linsenmitte muß an die Höhe h der strahlenden Fläche des Lasers angepaßt sein. Die Höhe der Linsenmitte kann über die Nutbreite b der Nut 3 eingestellt werden. Aufgrund der kristallographischen Eigenschaften des Siliziums berechnet sich der Böschungswinkel α zu

$$\alpha = \arctan(\sqrt{2}) = 54,7° \qquad (1)$$

Die Nutbreite b, die erforderlich ist, damit die Mitte der Linse mit einem Außenradius r in der Höhe h liegt, ist

$$b = r \cdot \sqrt{6} - h \cdot \sqrt{2}$$

Die den Zylindermantel berührenden Böschungslinien liegen in einer Tiefe von

$$m_y = r/\sqrt{3} - h$$

und haben einen Abstand von

$$m_x = r \cdot \sqrt{8/3}$$

von einander.

Für einen Linsenradius von 1500 µm und einer Höhe der optischen Achse über der Substratoberfläche von h = 100 µm für Epi-up-Laser erhält man

$b = 3533$ µm
$m_y = 766$ µm
$m_x = 2449$ µm

Bei h = 0 für Epi-down-Laser erhält man

$b = 3674$ µm
$m_y = 866$ µm
$m_x = 2449$ µm

Da die berührenden Mantellinien in einer Tiefe von 766 µm bzw. 866 µm unter der Substratoberfläche liegen, muß das Substrat mindestens diese Dicke haben, damit die Berührlinien noch innerhalb der Seitenflächen der Nut und nicht auf der unteren Kante liegen. Eine Substratdicke von 1000 µm ist zur Aufnahme der Linse ausreichend. Die Nut muß dann ganz durchgeätzt werden, wobei die Linse unter die Substratunterseite etwas hinaussteht. Die unter der Silizium-Trägerplatte befindliche Montageplatte 41 auf dem Peltierelement 40 muß im Bereich der Nut eine entsprechende Ausnehmung besitzen. Diese Ausnehmung kann entfallen, wenn die Silizium-Trägerplatte dicker ist als der Linsenradius. Einen hochgenauen axialen Anschlag für die Kollimierungslinse erhält man durch die Stirnfläche der Nut 3. Auf diese Weise läßt sich die Kollimierungslinse mit der durch die Silizium-Mikromechanik erreichbaren hohen Genauigkeit relativ zum Laser in allen drei Koordinaten justagefrei positionieren. Die Fixierung kann durch ein bekanntes Verfahren, wie zum Beispiel Kleben, geschehen. Vorteilhaft dabei ist, daß in der Auflagelinie der Klebespalt die Breite Null besitzt und daher keine Dejustage bei einer Schrumpfung des Klebers auftreten kann.

Die Silizium-Trägerplatte 2 dient außerdem zur Aufnahme der elektrischen Kontaktierungsleitungen für den Lager 1 und die Photodiode 8. Für Hochfrequenzanwendungen kann auf der Siliziumoberfläche eine Isolationsschicht beispielsweise aus Polyimid in einer Dicke von 10 - 20 µm aufgebracht werden, Diese Isolationsschicht dient als Dielektrikum für HF-Microstrip-Wellenleiter oder für koplanare HF-Wellenleiter. Bei Microstrip-Wellenleitern ist zwischen dem Silizium-Substrat und der Isolationsschicht eine ganzflächige Metallisierungsschicht als Masse. Bei koplanaren HF-Leitungen ist der elektrische Wellenleiter 13 von zwei seitlichen Masseleitungen 14 und 14' umgeben. Außerdem können auf dem Siliziumsubstrat noch weitere Bauteile montiert werden. So läßt sich der Thermistor 15 direkt in der Nähe des Lasers auf dem Siliziumsubstrat mit gutem Wärmekontakt zum Laser montieren. Auch Kondensatoren, Widerstände und Spulen, die für die HF-Ansteuerung des Lasers erforderlich sind oder sogar ein integrierter Ansteuerungsbaustein, lassen sich in unmittelbarer Nähe des Lasers auf dem Silizium-Substrat montieren. Da in der erfindungsgemäßen Lösung die HF-Leitungen bis unmittelbar an die Laserdiode herangeführt werden können, können so Frequenzen bis zu 30 GHz erreicht werden. Demgegenüber lassen sich nach dem Stand der Technik, wenn die HF-Leitungen von Ansteuerungsschaltungen außerhalb des Gehäuses über Gehäusedurchführungen und Bonddrähten zum Laser geführt werden müssen, nur etwa 2 - 3 GHz erreichen.

Bei den Lösungen nach dem Stand der Technik wird zur hermetisch dichten Lichtdurchführung ein schräg gestelltes Planfenster in den Strahlengang zwischen den Linsen gebracht. Im Ausführungsbeispiel wird die Fokussierungslinse 20 hermetisch dicht in die Öffnung 21 der Gehäusestirnwand 22 eingelötet oder eingeschweißt. Zum Einschweißen ist die Fokussierungslinse dazu mit einer schweißbaren Metallfassung versehen. Zum Einlötenhat die Linse ebenfalls eine Metallfassung mit einer lötbaren Beschichtung oder die lötbare Beschichtung ist direkt auf dem Rand der ungefaßten Linse aufgebracht. Dadurch kann das Gehäuse 23 gegenüber den Gehäusen, die für Ausführungen nach dem Stand der Technik erforderlich sind, wesentlich kostengünstiger sein, da statt des Stutzens mit dem schrägen Planfenster nur eine Öffnung 21 in der Gehäusestirnwand 22 aufgebracht werden muß. Die Linse 20 fokussiert das Lichtbündel auf die Stirnfläche 30 einer Faser 31. Zur Vermeidung von Rückreflexionen kann die Stirnfläche 30 gegenüber der optischen Achse geneigt sein. Die Faser 31 muß dann entsprechend der Lichtbrechung an der geneigten Stirnfläche ebenfalls unter einem schrägen Winkel in einer Führungshülse 31 gefaßt sein. Mit dieser Führungshülse, die in einer Buchse 33 läuft, kann die Faser axial justiert werden. Zur lateralen Justage wird die Stirnfläche der Buchse 33 auf der Stirnfläche einer Abstandshülse 34 verschoben. Die Fixierung der axialen und lateralen Position geschieht vorzugsweise durch Laserschweißen. Die axiale und laterale Justage sowie die Fixierung kann vorteilhafterweise in einem Arbeitsgang mit automatischer Steuerung durchgeführt werden. Dieser automatisierbare Arbeitsschritt ist der einzige aktive Justageschritt, der bei der erfindungsgemäßen Lösung erforderlich ist. Die Toleranzen sind dabei so groß, daß eine Dejustage beim Laserschweißen nur einen sehr geringen Einfluß auf den Koppelwirkungsgrad hat.

**Patentansprüche**

1. Lasermodul mit

   - einem Halbleiterlaser (1),
   - einem Lichtwellenleiter (31), insbesondere einer Einmodenfaser,
   - einer Koppeloptik, bestehend aus einer Kollimierungslinse (5) und einer Fokussierungslinse (20), zur Einkopplung von Laserlicht in den Lichtwellenleiter (31),
   - einer Silizium-Trägerplatte (2), die mittels anisotroper Ätztechnik mikromechanisch strukturiert ist und auf einer Seite eine erste Nut (3) aufweist zur Aufnahme der Kollimierungslinse (5),
   - einem Isolator (6), der im Strahlengang zwischen den beiden Linsen (5, 20) der Koppeloptik in einer Nut angeordnet ist,
   - einer Monitordiode (8),
   - einem Peltierkühler (40),

   dadurch gekennzeichnet,

   - daß der Isolator (6) in der selben Nut (3) wie die Kollimierungslinse (5) angeordnet ist,
   - daß fluchtend zur ersten Nut (3) auf der selben Seite der Silizium-Trägerplatte (2) eine zweite Nut (4) angeordnet ist, die zur Aufnahme der Monitordiode (8) dient und von der ersten Nut (3) durch einen Steg (10) getrennt ist,
   - daß der Halbleiterlaser (1) auf dem Steg (10) der Silizium-Trägerplatte (2) zwischen den Enden der Nuten (3, 4) montiert ist,
   - daß ein Gehäuse (23) für den Halbleiterlaser (1) vorgesehen ist, das eine Gehäusestirnwand (22) aufweist, in die zwischen Isolator (6) und Lichtwellenleiter (31) ein geneigtes Fenster oder die Fokussierungslinse (20) hermetisch dicht eingebracht ist und

- daß der Lichtwellenleiter (31) in drei Richtungen justiert außen am Gehäuse (23) befestigt ist.

2. Lasermodul nach Anspruch 1, dadurch gekennzeichnet,
daß auf dem Steg (10) V-Nuten (11,11') vorgesehen sind, die als Marken zur Ausrichtung des Halbleiterlasers (1) dienen.

3. Lasermodul nach einem der Ansprüche 1 oder 2, dadurch gekennzeichnet,
daß die Monitordiode (8) an der vom Laser (1) entfernten geneigten Seitenwand der Nut (4) befestigt ist.

4. Lasermodul nach einem der Ansprüche 1 bis 3, dadurch gekennzeichnet,

daß die Breite des Steges (10) gleichgroß oder geringfügig größer als die Länge des Lasers (1) ist, falls dieser seine strahlende Zone nahe der Oberseite aufweist oder
daß die Breite des Steges (10) gleichgroß oder geringfügig kleiner als die Länge des Lasers (1) ist, falls dieser seine strahlende Zone nahe der Unterseite aufweist.

5. Lasermodul nach einem der Ansprüche 1 bis 4, dadurch gekennzeichnet,
daß auf der Silizium-Trägerplatte (2) elektrische Kontaktierungsleitungen, Bauteile HF-Mikrostrip-Wellenleiter und/oder Ansteuerschaltungen, -bausteine vorgesehen sind.

6. Lasermodul nach einem der bisherigen Ansprüche, dadurch gekennzeichnet,
daß die Silizium-Trägerplatte (2) auf dem Peltierkühler (40) befestigt ist.

**Claims**

1. Laser module having

- a semiconductor laser (1),
- an optical waveguide (31), in particular a single-mode fibre,
- coupling optics, consisting of a collimating lens (5) and a focusing lens (20), for coupling laser light into the optical waveguide (31),
- a silicon support plate (2) which is micromechanically structured by means of anisotropic etching technology and has a first groove (3) on one side for receiving the collimating lens (5),
- an isolator (6), which is arranged in the optical path in a groove between the two lenses (5, 20) of the coupling optics,
- a monitor diode (8),
- a Peltier cooling element (40),

characterized in that

- the isolator (6) is arranged in the same groove (3) as the collimating lens (5),
- a second groove (4) is arranged in line with the first groove (3) on the same side of the silicon support plate (2), the second groove (4) being used to receive the monitor diode (8) and being separated from the first groove (3) by a span (10),
- the semiconductor laser (1) is mounted on the span (10) of the silicon support plate (2) between the ends of the grooves (3, 4),
- a housing (23) for the semiconductor laser (1) is provided, which has a housing end wall (22) in which an inclined window or the focusing lens (20) is hermetically inserted between the isolator (6) and the optical waveguide (31), and
- the optical waveguide (31) is fastened externally to the housing (23) while being adjusted in three directions.

2. Laser module according to Claim 1, characterized in that V-grooves (11, 11') which serve as marks for aligning the semiconductor laser (1) are provided on the span (10).

3. Laser module according to one of Claims 1 and 2, characterized in that the monitor diode (8) is fastened on the inclined side wall of the groove (4) remote from the laser (1).

4. Laser module according to one of Claims 1 to 3, characterized in that the width of the span (10) is the same size or slightly greater than the length of the laser (1), if the latter has its radiating zone near the upper side, or in that the width of the span (10) is the same size or slightly less than the length of the laser (1), if the latter has its radiating zone near the lower side.

5. Laser module according to one of Claims 1 to 4, characterized in that electrical contact lines, components of RF microstrip waveguides and/or drive circuits or modules are provided on the silicon support plate (2).

6. Laser module according to one of the preceding claims, characterized in that the silicon support plate (2) is fastened to the Peltier cooling element (4).

## Revendications

1. Module laser, comprenant :

    - un laser à semi-conducteur (1),
    - un guide d'ondes lumineuses (31), en particulier une fibre optique monomode,
    - une optique de couplage, consistant en une lentille de collimation (5) et une lentille de focalisation (20), servant à l'accouplement de la lumière laser dans le guide d'ondes lumineuses (31),
    - une plaque de support en silicium (2), qui est structurée de façon micromécanique, au moyen d'une technique de gravure anisotrope et qui présente sur un côté une première rainure (3), qui sert à recevoir la lentille de collimation (5),
    - un isolateur (6), qui est disposé dans une rainure sur le trajet du rayonnement entre les deux lentilles (5, 20) de l'optique de couplage,
    - une diode moniteur (8),
    - un refroidisseur par effet Peltier (40),

    caractérisé en ce qu'

    - on dispose en alignement avec la première rainure (3) sur le même côté de la plaque de support en silicium (2) une deuxième rainure (4), qui sert à recevoir la diode moniteur (8), et est séparée de la première rainure (3) par une entretoise (10),
    - on monte le laser à semi-conducteur (1) sur l'entretoise (10) de la plaque de support en silicium (2) entre les extrémités des rainures (3, 4),
    - on prévoit un boîtier (23) pour le laser à semi-conducteur (1), qui présente une paroi frontale (22) dans laquelle on pratique de façon hermétiquement étanche une fenêtre appropriée ou l'on met la lentille de focalisation (20) entre l'isolateur (6) et le guide d'ondes lumineuses (31) et
    - le guide d'ondes lumineuses (31) est fixé de façon ajustée dans trois directions à l'extérieur sur le boîtier (23).

2. Module laser selon la revendication 1,
    caractérisé en ce qu'
    on prévoit sur l'entretoise (10) des rainures en V (11, 11'),qui servent de marques pour orienter le laser à semi-conducteur (1).

3. Module laser, selon l'une des revendications 1 ou 2,
    caractérisé en ce que
    la diode moniteur (8) est fixée sur la paroi latérale de la rainure (4), inclinée, éloignée du laser (1).

4. Module laser selon l'une des revendications 1 à 3,

caractérisé en ce que

    - la largeur de l'entretoise (10) a la même grandeur ou est à peine plus grande que la longueur du laser (1), au cas où celui-ci présente sa zone de rayonnement à proximité de sa face supérieure ou
    - la largeur de l'entretoise (10) est aussi grande ou à peine plus petite que la longueur du laser (1), au cas où celui-ci présente sa zone de rayonnement à proximité de sa face inférieure.

5. Module laser selon l'une des revendications 1 à 4,
    caractérisé en ce qu'
    on prévoit sur la plaque de support en silicium (2) des lignes électriques de bonding, des guides d'ondes à ruban à composants haute fréquence et/ou des circuits et des blocs d'activation.

6. Module laser selon l'une des précédentes revendications,
    caractérisé en ce que
    la plaque de support en silicium (2) est fixé sur le refroidisseur par effet Peltier (40).

Fig. 1

Fig. 2

Fig. 3

Fig. 4

Fig. 5

Fig. 6

Fig. 7